# EUROPEAN PATENT SPECIFICATION

(11) **EP 4 270 640 B1**
(45) Date of publication and mention of the grant of the patent: **10.12.2025**
(21) Application number: 22921012.5
(22) Date of filing: 27.12.2022
(51) Int. Cl.: H01Q 1/24, H04M 1/02, H01Q 13/10

(54) **ANTENNA SLOT STRUCTURE AND ELECTRONIC DEVICE**
ANTENNENSCHLITZSTRUKTUR UND ELEKTRONISCHE VORRICHTUNG
STRUCTURE DE FENTE D'ANTENNE ET DISPOSITIF ÉLECTRONIQUE

(30) Priority: 21.02.2022 CN 202210157230
(43) Date of publication of application: 01.11.2023
(73) Proprietor: Honor Device Co., Ltd., Shenzhen, Guangdong 518040 (CN)
(72) Inventor: LIU, Jianfeng, Shenzhen, Guangdong 518040 (CN); WANG, Hongxing, Shenzhen, Guangdong 518040 (CN); YANG, Lijun, Shenzhen, Guangdong 518040 (CN)
(74) Representative: Isarpatent
(86) International application number: PCT/CN2022/142499
(87) International publication number: WO 2023/155603

(56) References cited:
- CN-A- 108 281 753
- CN-A- 109 586 031
- CN-A- 110 212 287
- CN-U- 214 336 900
- JP-A- 2013 042 376
- US-A1- 2018 070 465
- US-A1- 2020 076 058
- US-A1- 2022 006 176

## Description

### TECHNICAL FIELD

This disclosure generally relates to the field of terminal technologies, and the invention in particular relates to an antenna slot structure and an electronic device.

### BACKGROUND

Currently, electronic devices can support mobile communication functions such as 2G, 3G, 4G, and 5G, and/or support wireless communication functions such as wireless local area networks (Wireless Local Area Networks, WLANs), Bluetooth (Bluetooth, BT), the global navigation satellite system (Global Navigation Satellite System, GNSS), frequency modulation (Frequency Modulation, FM), the near field communication (Near Field Communication, NFC) technology, and the infrared (Infrared, IR) technology. To implement the foregoing communication functions, the electronic devices need to be equipped with corresponding antennas.

An electronic device is generally provided with an antenna slot on a metal frame of a housing. A plurality of antenna slots may be arranged. In addition, an antenna is positioned close to the antenna slot. The antenna slot provides a channel for signals sent or received by the antenna. Moreover, to improve the airtightness of the electronic device and ensure the dustproof and waterproof capabilities of the electronic device, the antenna slot is generally filled with insulating plastic, and the insulating plastic is tightly bonded to the metal frame at the antenna slot.

However, during assembly and factory delivery of an electronic device, the electronic device may be bent or squeezed, or encounter another case, and when a user uses the electronic device, the electronic device may be bent, squeezed, or dropped, or encounter another case. The foregoing cases may cause the insulating plastic filled at the antenna slot to be no longer tightly bonded to the metal frame. As a result, the airtightness of the electronic device is destroyed, and the dustproof and waterproof capabilities of the electronic device are degraded.

US 2020/076058 A1 discloses to a multi-segment housing for an electronic device that includes multiple conductive segments that are structurally coupled by one or more non-conductive housing segments or splits. One or more of the conductive segments may be configured to operate as an antenna and the non-conductive housing segments may provide electrical insulation between the conductive segment and one or more adjacent housing segments. The non-conductive housing segment may be formed from a polymer having an array of fibers dispersed within the polymer. The fibers may be aligned along one or more fiber directions, which may be substantially perpendicular to an exterior surface of the housing.

US 2018/070465 A1 discloses an electronic device having multiple housing components interlocked together by a molded material. In order to provide interlocking surfaces for the molded material, the housing components can include various geometries designed to receive and retain the molded material such that the housing components are secured with one another. For example, a first housing part can undergo several material removal operations to form multiple ribs, each with through holes. When the molded material extends along the ribs and into the through holes, the molded material cures and interlocks with the first housing part. A second housing part can include several stepped indentions that receive the molded material. Also, a third housing part can include a dovetail indention to receive the molded material such that the first and second housing parts interlock with the third housing part. The indentions can provide retention in three dimensions to protect against decoupling.

US 2022/006176 A1 discloses a device that includes a display and a housing. The housing surrounds the display and has four corners defining portions of an exterior surface of the device. The housing includes a first housing segment defining at least part of a first corner of the four corners and configured to operate as an antenna; a second housing segment defining at least part of a second corner of the four corners; and a third housing segment defining at least part of a third corner of the four corners. The third corner forms part of the housing diagonally opposite the second corner. The housing further includes a non-conductive housing component that structurally couples the first housing segment to another portion of the housing.

### SUMMARY

The object of the present invention is to resolve the foregoing problems and to provide an antenna slot structure and an electronic device, which improve bonding strength between the insulating plastic and the metal frame at the antenna slot, enhances the airtightness of the electronic device, and further ensures the dustproof and waterproof capabilities of the electronic device. This object is solved by the attached independent claims and further embodiments and improvements of the invention are listed in the attached dependent claims. Hereinafter, up to the "brief description of the drawings", expressions like "...aspect according to the invention", "according to the invention", or "the present invention", relate to technical teaching of the broadest embodiment as claimed with the independent claims. Expressions like "implementation", "design", "optionally", "preferably", "scenario", "aspect" or similar relate to further embodiments as claimed, and expressions like "example", "...aspect according to an example", "the disclosure describes", or "the disclosure" describe technical teaching which relates to the understanding of the invention or its embodiments, which, however, is not claimed as such.

According to a first aspect according to the invention as defined in the appended claims, the invention provides an antenna slot structure applied to an electronic device with an antenna. The antenna slot structure includes insulating plastic and a metal frame. The metal frame is separated into a first part and a second part by an antenna slot. The first part and/or the second part is provided with a first groove at the antenna slot. The first groove starts from the antenna slot and extends toward a direction away from the antenna slot. The insulating plastic fills the first groove and the antenna slot.

The antenna slot is equivalent to a fracture, and cross sections of the first part and the second part are opposite to each other. When the first part is provided with a first groove, a notch of the first groove starts from the antenna slot and extends toward a direction away from the antenna slot on the first part, and the notch of the first groove is located on a cross section corresponding to the first part; and when the second part is provided with a first groove, a notch of the first groove starts from the antenna slot and extends toward a direction away from the antenna slot on the second part, and the notch of the first groove is located on a cross section corresponding to the second part. After the first groove and the antenna slot are both filled with the insulating plastic, a contact area between the insulating plastic and the metal frame is increased, connection stability and bonding strength between the insulating plastic and the metal frame are further improved, and a thickness of insulating plastic at the first groove is increased, so that when the antenna slot structure is bent, squeezed, or dropped, or encounters another case, possibility of cracking is reduced. Therefore, the airtightness of the electronic device is enhanced, and the dustproof and waterproof capabilities of the electronic device are further ensured.

In a possible implementation, a concave surface of the first groove may include a milled trench and/or a laser carving to further improve the connection stability and bonding strength between the metal frame and the insulating plastic. With the milled trench or the laser carving on the concave surface of the first groove, a contact area between the insulating plastic and the metal frame is increased, the connection stability and bonding strength between the insulating plastic and the metal frame are further improved, so that when the antenna slot structure is bent, squeezed, or dropped, or encounters another case, the insulating plastic at the concave surface of the first groove and the metal frame do not tend to relatively move. Therefore, possibility of cracking of connection between the insulating plastic at the concave surface of the first groove and the metal frame is reduced, the airtightness of the electronic device is enhanced, and the dustproof and waterproof capabilities of the electronic device are further ensured.

According to the invention, the metal frame includes a first side and a second side connected in sequence, and the first groove is located on the first side. At least one of the first part and the second part is further provided with one or more second grooves on the second side. The insulating plastic covers the first side and the second side and fills the one or more second grooves.

After the second groove and the antenna slot are both filled with the insulating plastic, a contact area between the insulating plastic and the metal frame is increased, connection stability and bonding strength between the insulating plastic and the metal frame are further improved, the second groove structure can limit the insulating plastic, and a thickness of the insulating plastic is increased, so that when the antenna slot structure is bent, squeezed, or dropped, or encounters another case, the possibility of cracking is reduced. Therefore, the airtightness of the electronic device is enhanced, and the dustproof and waterproof capabilities of the electronic device are further ensured.

In a possible but not claimed implementation, at least one of the first part and the second part is provided with one second groove on the second side. The second groove extends to the first side; and a notch of the second groove on the first side is entirely located on the concave surface of the first groove, or a notch of the second groove on the first side is partially located on the concave surface of the first groove.

According to the invention, at least one of the first part and the second part is provided with a plurality of second grooves on the second side; the plurality of second grooves extend to the first side; a notch of one of the plurality of second grooves on the first side is partially located on the concave surface of the first groove; and the plurality of second grooves include at least one second groove whose notch on the first side is located outside the first groove.

In a possible implementation, the plurality of second grooves further include at least one second groove whose notch on the first side is entirely located on the concave surface of the first groove.

In a possible implementation, a concave surface of the one or more second grooves includes at least one of the following: a milled trench or a laser carving. With the milled trench or the laser carving on the concave surface of the second groove, a contact area between the insulating plastic and the metal frame is further increased, connection stability and bonding strength between the insulating plastic and the metal frame are improved, so that when the antenna slot structure is bent, squeezed, or dropped, or encounters another case, the insulating plastic at the concave surface of the second groove and the metal frame do not tend to relatively move. Therefore, possibility of cracking of the insulating plastic at the concave surface of the second groove is reduced, the airtightness of the electronic device is enhanced, and the dustproof and waterproof capabilities of the electronic device are further ensured.

In a possible implementation, the one or more second grooves include at least one of the following: a through groove or a blind groove.

In a possible implementation, the first part and the second part both include the second groove, and a quantity of second grooves included in the first part is equal to a quantity of second grooves included in the second part.

In a possible implementation, the first part and the second part both include the first groove, and a quantity of first grooves included in the first part is equal to a quantity of first grooves included in the second part.

According to a second aspect, wherein the second aspect and any of its implementations and options below are not claimedthis technical disclosure further provides the following antenna slot structure. The antenna slot structure includes insulating plastic and a metal frame. The metal frame includes a first part and a second part, and the first part and the second part are separated to form an antenna slot. The metal frame includes a first side and a second side connected in sequence. At least one of the first part and the second part is provided with one or more second grooves on the second side. The insulating plastic covers the first side and the second side and fills the antenna slot and the one or more second grooves.

In the solution, after the second groove and the antenna slot are both filled with the insulating plastic, a contact area between the insulating plastic and the metal frame is increased, connection stability and bonding strength between the insulating plastic and the metal frame are further improved, the second groove structure can limit the insulating plastic, and a thickness of the insulating plastic is increased, so that when the antenna slot structure is bent squeezed, or dropped, or encounters another case, possibility of cracking is reduced. Therefore, the airtightness of the electronic device is enhanced, and the dustproof and waterproof capabilities of the electronic device are further ensured.

In a possible but not claimed implementation, at least one of the first part and the second part is provided with a first groove at the antenna slot; the first groove is located on the first side; the first groove starts from the antenna slot and extends toward a direction away from the antenna slot; and the insulating plastic fills the first groove.

In a possible but not claimed implementation, a concave surface of the first groove includes at least one of the following: a milled trench or a laser carving.

In a possible but not claimed implementation, at least one of the first part and the second part is provided with one second groove on the second side; the second groove extends to the first side; and a notch of the second groove on the first side is entirely located on the concave surface of the first groove, or a notch of the second groove on the first side is partially located on the concave surface of the first groove.

In a possible but not claimed implementation, at least one of the first part and the second part is
provided with one or more second grooves on the second side; the plurality of second grooves extend to the first side; a notch of one of the plurality of second grooves on the first side is partially located on the concave surface of the first groove; and the plurality of second grooves include at least one second groove whose notch on the first side is located outside the first groove.

In a possible but not claimed implementation, the plurality of second grooves further include at least one second groove whose notch on the first side is entirely located on the concave surface of the first groove.

In a possible but not claimed implementation, a concave surface of the one or more second grooves includes at least one of the following: a milled trench or a laser carving.

In a possible but not claimed implementation, the one or more second grooves include at least one of the following: a through groove or a blind groove.

According to a third aspect according to the invention, this invention further provides an electronic device. The electronic device may be, although not claimed as such, a mobile phone, a notebook computer, a wearable electronic device (such as a smart watch), a tablet computer, or other electronic devices with an antenna. The electronic device includes one or more antenna slot structures provided in the first aspect.

As the antenna slot structure of the electronic device is provided with the first groove and/or the second groove, after the groove and the antenna slot are both filled with the insulating plastic, a contact area between the insulating plastic and the metal frame is increased, and the connection stability and the bonding strength between the insulating plastic and the metal frame are further improved. Specifically, after the first groove is filled with the insulating plastic, a thickness of insulating plastic near the antenna slot is improved, and possibility of cracking of the insulating plastic near the antenna slot is reduced. The second groove can limit and clamp the insulating plastic, so that when the antenna slot structure is bent, squeezed, or dropped, or encounters another case, possibility of cracking is reduced. Therefore, the airtightness of the electronic device is enhanced, and the dustproof and waterproof capabilities of the electronic device are further ensured.

In a possible implementation, the electronic device includes a plurality of antenna slot structures, and further includes a first short edge, a first long edge, a second short edge, and a second long edge connected in sequence. The plurality of antenna slot structures include a first group of antenna slot structures and a second group of antenna slot structures. The first group of antenna slot structures is located on the first long edge; and the second group of antenna slot structures is located on the second long edge.

In a possible implementation, the plurality of antenna slot structures further includes a third group of antenna slot structures and a fourth group of antenna slot structures. The third group of antenna slot structures is located on the first short edge; and the fourth group of antenna slot structures is located on the second short edge.

In the following description, features which in the above summary of the invention have been marked as "not claimed" or "according to the invention" are also hereinafter, when they are described and explained with reference to the drawings, to be understood as "not claimed" or "not part of the invention" or "according to the invention". Even if sometimes in the description of the embodiments below, features marked above "according to the invention" or "the invention" are referred to in connection with the words "can" or "may" or other expressions which contain the notion of them being "optional", it should be understood that indeed such features are considered essential to the invention as claimed and not optional.

### BRIEF DESCRIPTION OF DRAWINGS

FIG. 1 is a schematic diagram of a mobile phone;
FIG. 2 is a schematic diagram of an antenna slot structure;
FIG. 3A is a schematic diagram of an antenna slot structure according to an embodiment of this application;
FIG. 3B is an exploded view corresponding to FIG. 3A according to an embodiment of this application;
FIG. 4A is a schematic diagram of a metal frame of an antenna slot structure according to an embodiment of this application;
FIG. 4B is a schematic diagram 1 of a metal frame corresponding to FIG. 3A from a different perspective according to an embodiment of this application;
FIG. 4C is a schematic diagram 2 of a metal frame corresponding to FIG. 3A from a different perspective according to an embodiment of this application;
FIG. 5 is a schematic diagram of insulating plastic of an antenna slot structure according to an embodiment of this application;
FIG. 6 is a schematic diagram of a metal frame of another antenna slot structure according to an embodiment of this application;
FIG. 7A is a schematic diagram of a metal frame of still another antenna slot structure according to an embodiment of this application;
FIG. 7B is a schematic diagram of a metal frame corresponding to FIG. 7A from another perspective according to an embodiment of this application;
FIG. 8 is a schematic diagram of insulating plastic of another antenna slot structure according to an embodiment of this application;
FIG. 9 is a schematic diagram of a metal frame of yet another antenna slot structure according to an embodiment of this application;
FIG. 10A is a schematic diagram of a metal frame of another antenna slot structure according to an embodiment of this application;
FIG. 10B is a schematic diagram 1 of a metal frame corresponding to FIG. 10A from a different perspective according to an embodiment of this application;
FIG. 10C is a schematic diagram 2 of a metal frame corresponding to FIG. 10A from a different perspective according to an embodiment of this application;
FIG. 11 is a schematic diagram of insulating plastic of still another antenna slot structure according to an embodiment of this application;
FIG. 12A is a schematic diagram of a metal frame of still another antenna slot structure according to an embodiment of this application;
FIG. 12B is a schematic diagram of a metal frame corresponding to FIG. 12A from a different perspective according to an embodiment of this application;
FIG. 13A is a schematic diagram of a metal frame of yet another antenna slot structure according to an embodiment of this application;
FIG. 13B is a schematic diagram of a metal frame corresponding to FIG. 13A from a different perspective according to an embodiment of this application;
FIG. 14A is a schematic diagram of a metal frame of another antenna slot structure according to an embodiment of this application;
FIG. 14B is a schematic diagram of a metal frame corresponding to FIG. 14A from a different perspective according to an embodiment of this application;
FIG. 15A is a schematic diagram of a metal frame of still another antenna slot structure according to an embodiment of this application;
FIG. 15B is a schematic diagram of a metal frame corresponding to FIG. 15A from a different perspective according to an embodiment of this application;
FIG. 16A is a schematic diagram of a metal frame of yet another antenna slot structure according to an embodiment of this application;
FIG. 16B is a schematic diagram of a metal frame corresponding to FIG. 16A from a different perspective according to an embodiment of this application;
FIG. 17A is a schematic diagram of a metal frame of another antenna slot structure according to an embodiment of this application;
FIG. 17B is a schematic diagram of a metal frame corresponding to FIG. 17A from a different perspective according to an embodiment of this application;
FIG. 18A is a schematic diagram of a metal frame of yet another antenna slot structure according to an embodiment of this application;
FIG. 18B is a schematic diagram of a metal frame corresponding to FIG. 18A from a different perspective according to an embodiment of this application; and
FIG. 19 is a schematic diagram of an electronic device according to an embodiment of this application.

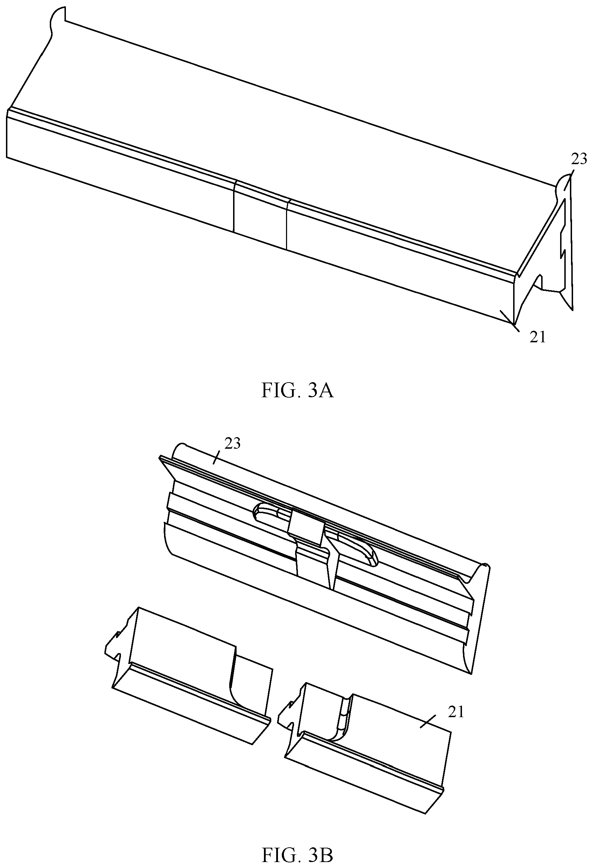

FIGs. 3-9, 15, and 18 disclose antenna slot structures that do not have all the claimed features but are nevertheless useful for the understanding of the present invention as defined by the appended claims.

### DESCRIPTION OF EMBODIMENTS

To enable those skilled in the art to understand the solutions of this application more clearly, application scenarios of the technical solutions of this application are first described below.

The solution provided in this application is applied to an electronic device with an antenna. This application does not specifically limit a type of the electronic device, and the electronic device may be a mobile phone, a notebook computer, a wearable electronic device (such as a smart watch), a tablet computer, an augmented reality (augmented reality, AR) device, a virtual reality (virtual reality, VR) device, an in-vehicle device, or the like. A structure of the electronic device is described below with examples.

A communication function of the electronic device is implemented by an antenna group, a mobile communication module, a wireless communication module, a modem processor, a baseband processor, and the like.

An antenna group generally includes a plurality of antennas configured to implement a mobile communication function and a wireless communication function. Specifically, an antenna group is configured to transmit and receive electromagnetic wave signals. Each antenna in the electronic device may be configured to cover one or more communication frequency bands. Different antennas may further be multiplexed to increase antenna utilization. For example, an antenna in an antenna group may be multiplexed as a diversity antenna of a wireless local area network. In some other embodiments, an antenna may be used in combination with a tuning switch.

The mobile communication module may provide a solution to wireless communication such as 2G, 3G, 4G, 5G, or the like applied to the electronic device. The mobile communication module may include at least one filter, a switch, a power amplifier, a low noise amplifier (low noise amplifier, LNA), and the like. The mobile communication module may receive an electromagnetic wave through an antenna in the antenna group, perform processing such as filtering and amplification on the received electromagnetic wave, and send a processed electromagnetic wave to the modem processor for demodulation. The mobile communication module may further amplify a signal modulated by the modem processor, and convert the signal into an electromagnetic wave for radiation through an antenna in the antenna group. In some embodiments, at least some function modules of the mobile communication module may be arranged in a processor. In some embodiments, at least some function modules of the mobile communication module may be arranged in a same device as at least some modules of the processor.

The modem processor may include a modulator and a demodulator. The modulator is configured to modulate a low frequency baseband signal that is to be sent into a medium or high frequency signal. The demodulator is configured to demodulate the received electromagnetic wave signal into a low frequency baseband signal. Then, the demodulator sends the low frequency baseband signal obtained through demodulation to the baseband processor for processing. The low frequency baseband signal is transmitted to an application processor after being processed by the baseband processor. The application processor outputs a sound signal through an audio device (which is not limited to a speaker, a telephone receiver, and the like), or displays an image or a video through a display screen. In some embodiments, the modem processor may be an independent device. In some other embodiments, the modem processor may be independent of the processor and arranged in a same device as the mobile communication module or other function modules.

The wireless communication module may provide wireless communication solutions applied to the electronic device, including wireless local area networks (Wireless Local Area Networks, WLANs) (for example, a Wi-Fi network), Bluetooth (Bluetooth, BT), the global navigation satellite system (Global Navigation Satellite System, GNSS), frequency modulation (Frequency Modulation, FM), the near field communication (Near Field Communication, NFC) technology, the infrared (Infrared, IR) technology, and the like. The wireless communication module may be one or more devices integrating at least one communication processing module. The wireless communication module receives an electromagnetic wave through an antenna in the antenna group, performs frequency modulation and filtering on an electromagnetic wave signal, and sends a processed signal to the processor. The wireless communication module may further receive a to-be-sent signal from the processor, perform frequency modulation and amplification on the to-be-sent signal, and convert the to-be-sent signal into an electromagnetic wave for radiation through the antenna in the antenna group.

In some embodiments, the wireless communication technology may include a global system for mobile communications (global system for mobile communications, GSM), a general packet radio service (general packet radio service, GPRS), code division multiple access (code division multiple access, CDMA), wideband code division multiple access (wideband code division multiple access, WCDMA), time-division code division multiple access (time-division code division multiple access, TD-SCDMA), long term evolution (long term evolution, LTE), BT, the GNSS, WLAN, the NFC, FM, the IR technology, and/or the like. The GNSS may include a global positioning system (global positioning system, GPS), a global navigation satellite system (global navigation satellite system, GLONASS), and a beidou navigation satellite system (beidou navigation satellite system, BDS), a quasi-zenith satellite system (quasi-zenith satellite system, QZSS), and/or a satellite based augmentation system (satellite based augmentation system, SBAS).

To strengthen a body of an electronic device and improve look and feel of the electronic device, the electronic device generally adopts a metal frame, and an antenna slot is provided at the metal frame. A plurality of antenna slots may be arranged. In addition, an antenna is positioned close to the antenna slot. The antenna slot provides a channel for signals sent or received by the antenna.

In addition, an International Protection Marking (International Protection Marking, IEC 60529) is also referred to as an Ingress Protection Rating (Ingress Protection Rating) or an IP Code (IP Code), and is also referred to as a "waterproof rating", "dustproof rating", and the like sometimes, which defines a degree of protection capability that mechanical equipment and an electronic device can provide against ingress of solid foreign objects (including body parts such as fingers, dust, grit, and the like), ingress of liquids, and accidental contact. To improve the airtightness of the electronic device and ensure the dustproof and waterproof capabilities of the electronic device, insulating plastic is generally filled at the antenna slot, and the insulating plastic and a frame at the antenna slot are tightly bonded.

Implementations of an antenna slot structure are below using an example in which the electronic device is a mobile phone. Cases of electronic devices of other types are similar. Details are not described herein again.

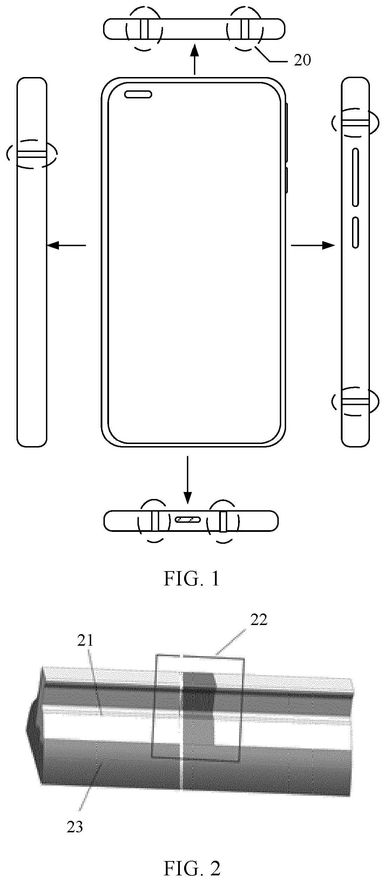

FIG. 1 is a schematic diagram of a mobile phone.

FIG. 1 shows the mobile phone and a left side view, a right side view, a top view, and a bottom view of the mobile phone. A layout and a quantity of antenna slot structures 20 arranged on a surrounding frame in FIG. 1 are only a possible implementation.

FIG. 2 is a schematic diagram of an antenna slot structure.

The antenna slot structure shown in the figure includes a metal frame 21 and insulating plastic 23. The metal frame 21 includes an antenna slot 22, and the insulating plastic 23 is filled on an inner side of the metal frame and is filled in the antenna slot 22.

During assembly and factory delivery of a mobile phone, the mobile phone may be bent or squeezed or encounter another case, and when a user uses the mobile phone, the mobile phone may be bent, squeezed, or dropped, or encounter another case. The foregoing case may cause the insulating plastic 23 filled at the antenna slot 20 to be no longer tightly bonded to the metal frame 21. As a result, the airtightness of the mobile phone is destroyed, and the actual dustproof and waterproof capabilities of the mobile phone are degraded. In this case, if the user still uses the mobile phone according to a theoretically corresponding international protection marking, the mobile phone may be damaged, and safety hazards may even exist.

To resolve the foregoing problems, this application provides an antenna slot structure and an electronic device, to improve the connection stability and bonding strength between the insulating plastic and the metal frame, so that when the antenna slot structure is bent, squeezed, or dropped, or encounters another case, the possibility of cracking is reduced. Therefore, the airtightness of the electronic device is enhanced, and the dustproof and waterproof capabilities of the electronic device are further ensured.

To make a person skilled in the art understand the technical solutions in this application more clearly, the following describes the technical solutions in the embodiments of this application with reference to the accompanying drawings in the embodiments of this application.

In the specification of this application, terms such as "first" and "second" are used merely for the purpose of description, and shall not be construed as indicating or implying relative importance or implying a quantity of indicated technical features.

It may be understood that orientation terms such as "upper", "lower", "left", and "right" in the following embodiments of this application are merely for ease of description. It is necessary to refer to directions in the accompanying drawings. The orientation terms do not constitute a limitation to the technical solutions in this application.

Refer to FIG. 3A, FIG. 3B, FIG. 4A, FIG. 4B, FIG. c, and FIG. 5 together. FIG. 3A is a schematic diagram of an antenna slot structure according to an embodiment of this application.

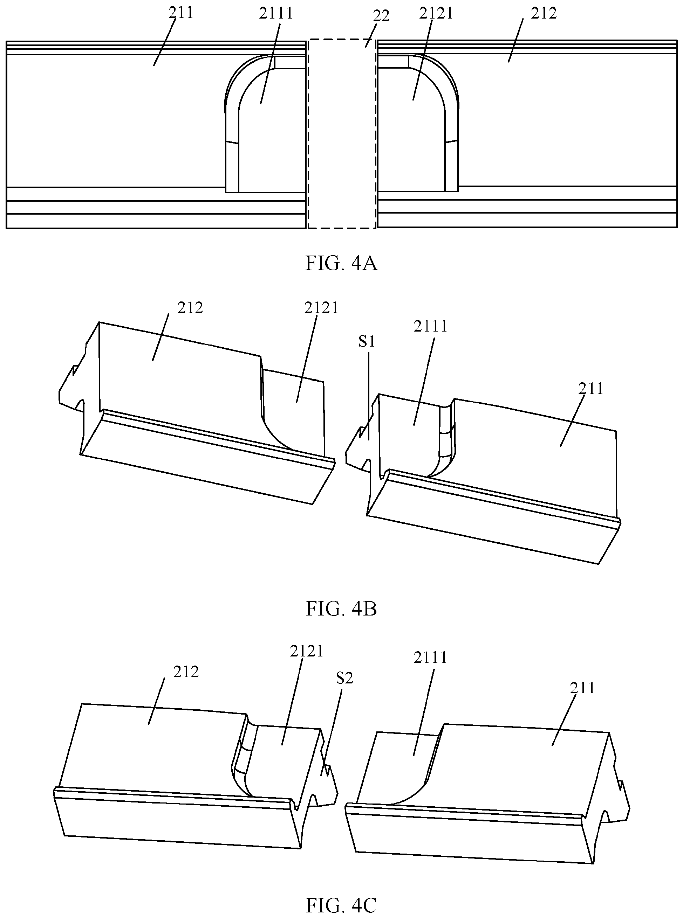

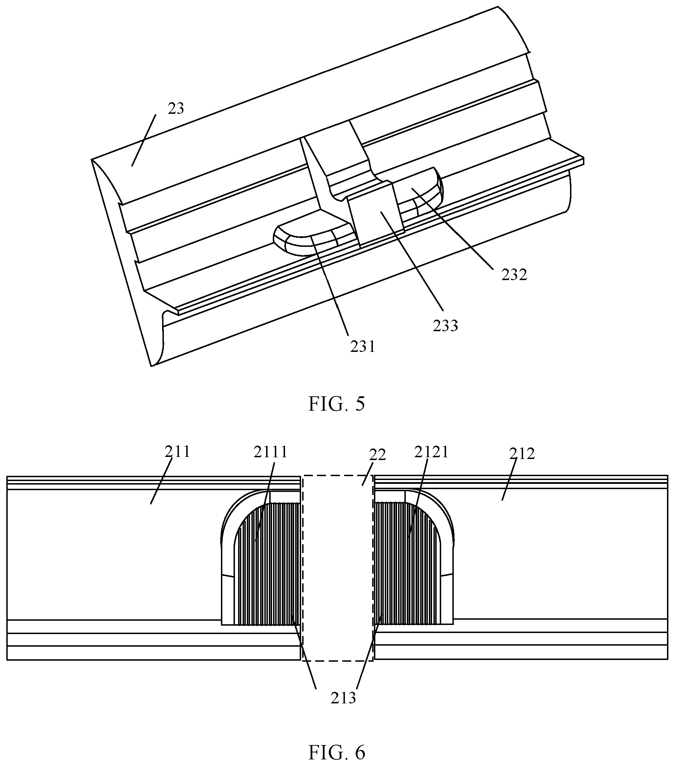

FIG. 3B is an exploded view corresponding to FIG. 3A according to an embodiment of this application. FIG. 4A is a schematic diagram of a metal frame of an antenna slot structure according to an embodiment of this application. FIG. 4B is a schematic diagram 1 of a metal frame corresponding to FIG. 3A from a different perspective according to an embodiment of this application. FIG. 4C is a schematic diagram 2 of a metal frame corresponding to FIG. 3A from a different perspective according to an embodiment of this application. FIG. 5 is a schematic diagram of insulating plastic of an antenna slot structure according to an embodiment of this application.

The antenna slot structure includes a metal frame 21 and insulating plastic 23.

FIG. 4 is a top view of the metal frame 21 in FIG. 3A after a perspective is adjusted.

The metal frame includes a first part 211 and a second part 212, and the first part 211 and the second part 212 are separated from each other to form an antenna slot 22. That is, the antenna slot 22 is equivalent to a fracture on the metal frame and divides the metal frame into the first part 211 and the second part 212.

Referring to FIG. 4B, the first part 211 forms a first cross section S1 at the antenna slot 22, and the first cross section S1 is a surface of the first part 211 adjacent to the antenna slot. Referring to FIG. 4C, the second part 212 forms a second cross section S2 at the antenna slot 22, and the second cross section S2 is a surface of the second part 202 adjacent to the antenna slot. The first cross section S1 and the second cross section S2 are opposite to each other.

At least one of the first part 211 and the second part 212 is provided with a first groove. An example in which the first part 211 and the second part 212 are both provided with a first groove is used for descriptions in this embodiment of this application. When only one of the first part 211 and the second part 212 is provided with a first groove, a principle of implementation is similar, and details are not described herein again.

The first part 211 is provided with a first groove 2111, a notch of the first groove 2111 starts from the antenna slot 22 and extends on the first part 211 in a direction away from the antenna slot 22, that is, starts from the antenna slot 22 and extends toward the left in FIG. 4. A width, a length, and a depth of the first groove 2111 are not specifically limited in this embodiment of this application.

The second part 212 is provided with a first groove 2121, a notch of the first groove 2121 starts from the antenna slot 22 and extends on the second part 212 in a direction away from the antenna slot 22, that is, starts from the antenna slot 22 and extends toward the right in FIG. 4. A width, a length, and a depth of the first groove 2121 are not specifically limited in this embodiment of this application.

In an actual application, when the first part 211 and the second part 212 are both provided with a first groove, the first grooves on the first part 211 and the second part 212 are generally distributed symmetrically, and have same parameters such as same widths, same lengths, and same depths.

FIG. 5 shows a form of the insulating plastic after curing. FIG. 5 and FIG. 3B are at different perspectives. When the insulating plastic 23 fills the first groove and the antenna slot, part of insulating plastic numbered 233 is filled in the antenna slot 22, part of insulating plastic numbered 231 is filled in the first groove 2111, and part of insulating plastic numbered 232 is filled in the first groove 2111.

A shape of the first groove shown in FIG. 4A to FIG. 4C is only a possible implementation. In an actual application, the first groove may be in another shape, for example, a shape such as a rectangle, a semi-circle, or a triangle.

In the solution provided in this embodiment of this application, after the first groove and the antenna slot are both filled with the insulating plastic, a contact area between the insulating plastic and the metal frame is increased, so that the connection stability and bonding strength between the insulating plastic and the metal frame are further improved. After the insulating plastic fills the first groove, a thickness of the insulating plastic is also increased, so that when the antenna slot structure is bent, squeezed, or dropped, or encounters another case, possibility of cracking is reduced. Therefore, the airtightness of the electronic device is enhanced, and the dustproof and waterproof capabilities of the electronic device are further ensured.

In addition, a milled trench or a laser carving may be further provided in the first groove, to further increase the contact area between the insulating plastic and the metal frame, thereby further improving the connection stability and bonding strength between the insulating plastic and the metal frame, which is described below in detail with the accompanying drawings.

FIG. 6 is a schematic diagram of a metal frame of another antenna slot structure according to an embodiment of this application.

A difference between FIG. 6 and FIG. 4A is that, for a first groove on the first part 211 and the second part 212, a milled trench or a laser carving on a concave surface of the first groove is marked with 213.

The milled trench is a trench processed on a surface of metal using a milling cutter. When the concave surface of the first groove is provided with a milled trench, a quantity, a width, and a depth of the milled trench is not specifically limited in this embodiment of this application.

A laser carving is a permanent marking carved on a surface of metal using a laser (laser) beam. When the concave surface of the first groove is provided with a laser carving, a quantity, a width, a depth, and the like of the laser carving are not specifically limited in this embodiment of this application.

With the milled trench or the laser carving on the concave surface of the first groove, a contact area between the insulating plastic and the metal frame is increased, the connection stability and the bonding strength between the insulating plastic and the metal frame are further improved, so that when the antenna slot structure is bent, squeezed, or dropped, or encounters another case, the insulating plastic at the concave surface of the first groove and the metal frame do not tend to relatively move. Therefore, possibility of cracking of connection between the insulating plastic at the concave surface of the first groove and the metal frame is reduced, the airtightness of the electronic device is enhanced, and the dustproof and waterproof capabilities of the electronic device are further ensured.

Another implementation of the antenna slot structure is described below.

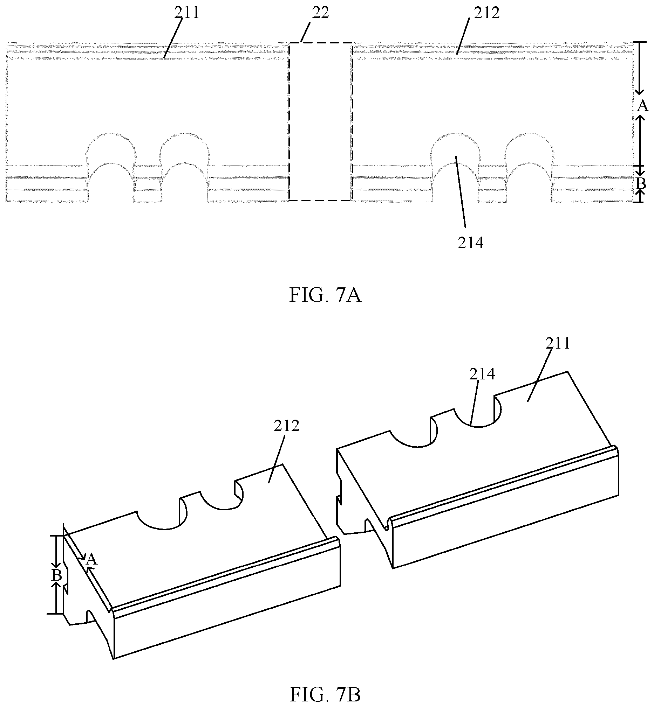

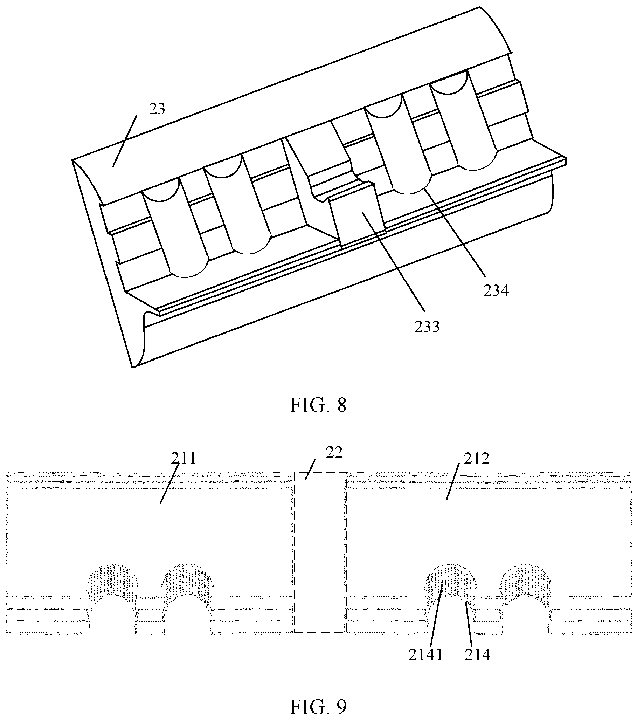

Refer to FIG. 7A, FIG. 7B, and FIG. 8 together. FIG. 7A is a schematic diagram of a metal frame of still another antenna slot structure according to an embodiment of this application. FIG. 7B is a schematic diagram of a metal frame corresponding to FIG. 7A from another perspective according to an embodiment of this application. FIG. 8 is a schematic diagram of insulating plastic of another antenna slot structure according to an embodiment of this application.

The antenna slot structure includes a metal frame and insulating plastic 23.

The metal frame includes a first part 211 and a second part 212, and the first part 211 and the second part 212 are separated from each other to form an antenna slot 22. That is, the antenna slot 22 is equivalent to a fracture on the metal frame and divides the metal frame into the first part 211 and the second part 212.

The first part 211 forms a first cross section at the antenna slot 22, and the second part 212 forms a second cross section at the antenna slot 22. The first cross section and the second cross section are opposite to each other.

The metal frame includes a first side and a second side connected in sequence. In FIG. 7A and FIG. 7B, the first side is an A side, and the second side is a B side.

At least one of the first part 211 and the second part 212 is provided with one or more second grooves on the second side 214. An example in which the first part 211 and the second part 212 are both provided with two second grooves 214 is used for descriptions in this embodiment of this application, and when only one of the first part 211 and the second part 212 is provided with a second groove 214, or another quantity of the second grooves 214 are provided, a principle of implementation is similar. Details are not described herein again.

The second groove 214 shown in FIG. 7A and FIG. 7B is a through groove, that is, the second groove 214 penetrates the second side. The second groove 214 shown in FIG. 7A and FIG. 7B is a semi-circular groove. The second groove 214 may be a groove of another shape, such as a rectangular groove, a triangular groove, or a T-shaped groove. In addition, a parameter of the second groove 214, such as a width and a depth, is not specifically limited in this embodiment of this application.

In addition, in some other embodiments, the second groove 214 may be a blind groove, that is, the second groove 214 may not penetrate the second side.

In an actual application, when the first part 211 and the second part 212 are both provided with a second groove, the first grooves on the first part 211 and the second part 212 are generally provided in pairs and have same parameters such as same widths, same lengths, and same depths, which makes the first part 211 and the second part 212 symmetrical relative to the antenna slot to facilitate processing and molding.

FIG. 8 shows a form of insulating plastic 23 after curing. The insulating plastic 23 covers the first side and the second side and fills the antenna slot 22 and the second groove 214.

When the insulating plastic 23 fills the second groove and the antenna slot, part of insulating plastic numbered 233 is filled in the antenna slot 22, and part of insulating plastic numbered 234 is filled in the second groove 214.

In the solution provided in this embodiment of this application, after the second groove and the antenna slot are both filled with the insulating plastic, a contact area between the insulating plastic and the metal frame is increased, connection stability and bonding strength between the insulating plastic and the metal frame are further improved, the second groove structure can limit the insulating plastic, and a thickness of the insulating plastic is increased, so that when the antenna slot structure is bent squeezed, or dropped, or encounters another case, possibility of cracking is reduced. Therefore, the airtightness of the electronic device is enhanced, and the dustproof and waterproof capabilities of the electronic device are ensured.

In addition, a milled trench or a laser carving may be provided in the second groove, which further improve the connection stability and bonding strength between the insulating plastic and the metal frame, and is described below in detail with the accompanying drawings.

FIG. 9 is a schematic diagram of a metal frame of yet another antenna slot structure according to an embodiment of this application.

For a second groove 214 on the first part 211 and the second part 212, a milled trench or a laser carving on a concave surface of the second groove is marked with 2141.

The milled trench is a trench processed on a surface of metal using a milling cutter. When the concave surface of the second groove is provided with a milled trench, a quantity, a width, a depth, and the like of the milled trench are not specifically limited in this embodiment of this application.

A laser carving is a permanent marking carved on a surface of metal using a laser (laser) beam. When the concave surface of the second groove is provided with a laser carving, a quantity, a width, a depth, and the like of the laser carving are not specifically limited in this embodiment of this application.

With the milled trench or the laser carving on the concave surface of the second groove, a contact area between the insulating plastic and the metal frame is further increased, connection stability and bonding strength between the insulating plastic and the metal frame are improved, so that when the antenna slot structure is bent, squeezed, or dropped, or encounters another case, the insulating plastic at the concave surface of the second groove and the metal frame do not tend to relatively move. Therefore, possibility of cracking of the insulating plastic at the concave surface of the second groove is reduced, the airtightness of the electronic device is enhanced, and the dustproof and waterproof capabilities of the electronic device are further ensured.

The antenna slot structure provided in the foregoing embodiments of this application includes the first groove or the second groove, and an implementation that an antenna slot structure includes both a first groove and a second groove is described below.

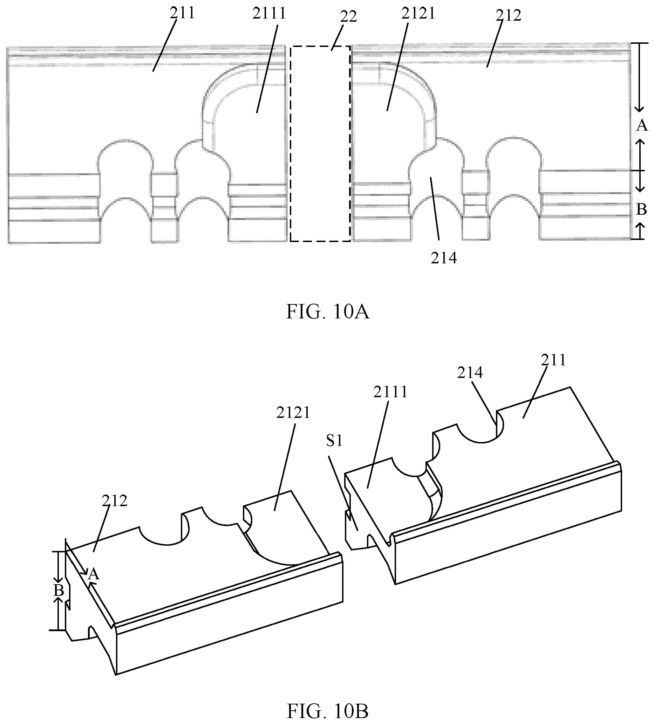

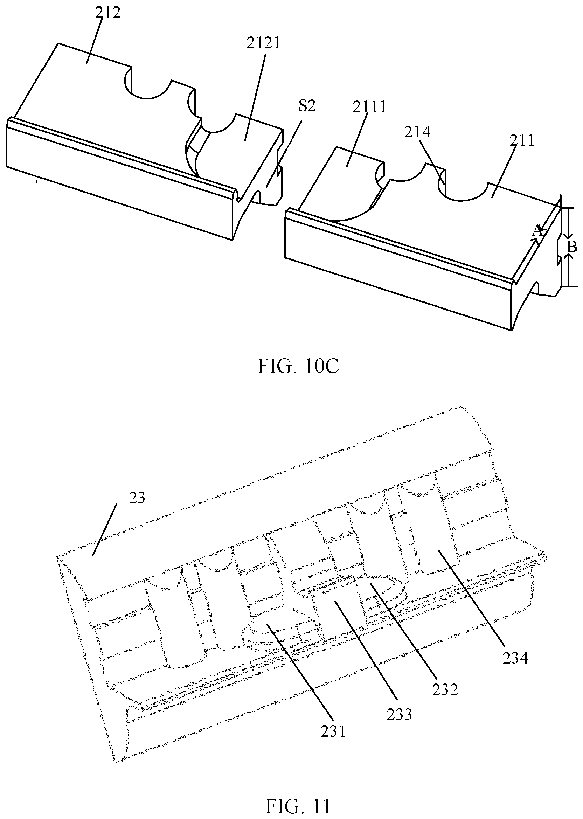

Refer to FIG. 10A, FIG. 10B, and FIG. 10C together. FIG. 10A is a schematic diagram of a metal frame of another antenna slot structure according to an embodiment of this application. FIG. 10B is a schematic diagram 1 of a metal frame corresponding to FIG. 10A from a different perspective according to an embodiment of this application. FIG. 10C is a schematic diagram 2 of a metal frame corresponding to FIG. 10A from a different perspective according to an embodiment of this application.

The antenna slot structure includes a metal frame and insulating plastic.

The metal frame includes a first part 211 and a second part 212, and the first part 211 and the second part 212 are separated from each other to form an antenna slot 22. That is, the antenna slot 22 is equivalent to a fracture on the metal frame and divides the metal frame into the first part 211 and the second part 212.

Referring to FIG. 10B, the first part 211 forms a first cross section S1 at the antenna slot 22. Referring to FIG. 10C, the second part 212 forms a second cross section S2 at the antenna slot 22. The first cross section S1 and the second cross section S2 are opposite to each other.

The metal frame includes a first side and a second side connected in sequence. In FIG. 10A to FIG. 10C, the first side is an A side, and the second side is a B side.

At least one of the first part 211 and the second part 212 is provided with a first groove on the first side. An example in which the first part 211 and the second part 212 are both provided with a first groove is used for descriptions in this embodiment of this application. When only one of the first part 211 and the second part 212 is provided with a first groove, a principle of implementation is similar, and details are not described herein again.

The first part 211 is provided with a first groove 2111, a notch of the first groove 2111 starts from the antenna slot 22 and extends on the first part 211 in a direction away from the antenna slot 22, that is, starts from the antenna slot 22 and extends toward the left in FIG. 10A.

The second part 212 is provided with a first groove 2121, a notch of the first groove 2121 starts from the antenna slot 22 and extends on the second part 212 in a direction away from the antenna slot 22, that is, starts from the antenna slot 22 and extends toward the right in FIG. 10A.

At least one of the first part 211 and the second part 212 is provided with one or more second grooves on the second side 214. An example in which the first part 211 and the second part 212 are both provided with two second grooves 214 is used for descriptions in this embodiment of this application, and when only one of the first part 211 and the second part 212 is provided with a second groove 214, or another quantity of the second grooves 214 are provided, a principle of implementation is similar. Details are not described herein again.

The second groove 214 shown in FIG. 10 is a through groove, that is, the second groove 214 penetrates the second side. In addition, in another possible implementation, the second groove may be a blind groove, that is, the second groove 214 may not penetrate the second side.

A width, a length, a depth, and the like of each first groove and each second groove are not specifically limited in this embodiment of this application. The first groove may be another shape, for example, a shape such as a rectangle, a semi-circle, or a triangle. The second groove 214 may be a groove of another shape, such as a rectangular groove, a triangular groove, or a T-shaped groove.

FIG. 11 is a schematic diagram of insulating plastic of still another antenna slot structure according to an embodiment of this application.

FIG. 11 shows a form of insulating plastic 23 corresponding to the metal frame shown in FIG. 10A to FIG. 10C after curing. The insulating plastic 23 covers the first side and the second side, and fills the antenna slot 22, each first groove, and each second groove.

When the insulating plastic 23 fills the first groove and the antenna slot, part of insulating plastic numbered 233 is filled in the antenna slot 22, part of insulating plastic numbered 231 is filled in the first groove 2111, part of insulating plastic numbered 232 is filled in the first groove 2111, and part of insulating plastic numbered 234 is filled in the second groove 214.

In the foregoing embodiment, the first part 211 and the second part 212 both include the first groove, and a quantity of first grooves included in the first part 211 is equal to a quantity of first grooves included in the second part 212; and the first part 211 and the second part 212 both include the second groove, and a quantity of second grooves included in the first part 211 is equal to a quantity of second grooves included in the second part 211, so that the antenna slot structure has good symmetry. In an actual application, a quantity of first grooves included in the first part 211 and the second part 212 may not be equal, and a quantity of second grooves included in the first part 211 and the second part 212 may not be equal, for example, the first part 211 includes two second grooves, and the second part 212 includes three second grooves.

In the solution provided in this embodiment of this application, after the antenna slot, each first groove, and each second groove are all filled with the insulating plastic, a contact area between the insulating plastic and the metal frame is increased, and the connection stability and the bonding strength between the insulating plastic and the metal frame are further improved. Specifically, after the first groove is filled with the insulating plastic, a thickness of insulating plastic near the antenna slot is improved, and possibility of cracking of the insulating plastic near the antenna slot is reduced. A structure of the second groove can limit and clamp the insulating plastic and increases a thickness of insulating plastic at the second groove, so that when the antenna slot structure is bent, squeezed, or dropped, or encounters another case, the possibility of cracking is reduced. Therefore, the airtightness of the electronic device is enhanced, and the dustproof and waterproof capabilities of the electronic device are ensured.

In addition, a milled trench may be provided in the first groove and/or the second groove, or a laser carving may be provided in the first groove and/or the second groove, to further improve the connection stability and the bonding strength between the insulating plastic and the metal frame, which is described below in detail with the accompanying drawings.

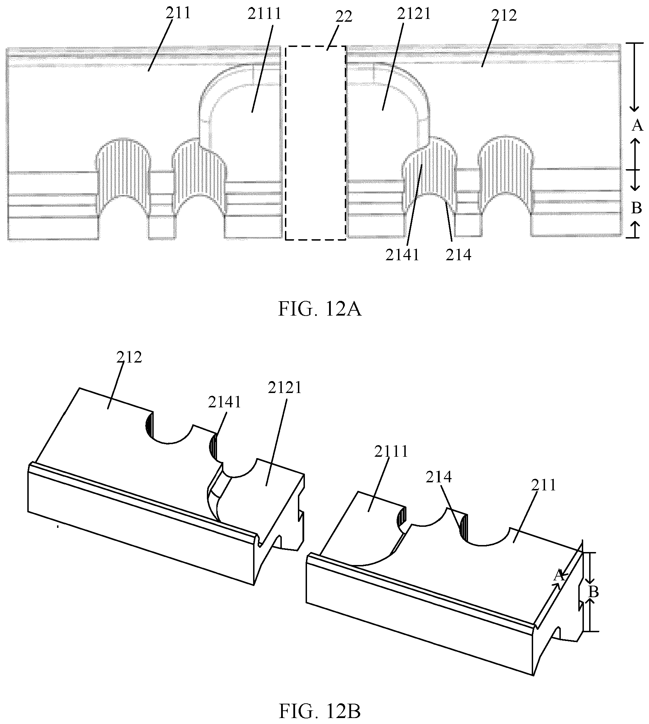

Refer to FIG. 12A and FIG. 12B together. FIG. 12A is a schematic diagram of a metal frame of still another antenna slot structure according to an embodiment of this application. FIG. 12B is a schematic diagram of a metal frame corresponding to FIG. 12A from a different perspective according to an embodiment of this application.

For a second groove 214 on the first part 211 and the second part 212, a milled trench or a laser carving on a concave surface of the second groove is marked with 2141.

With the milled trench or the laser carving on the concave surface of the second groove, a contact area between the insulating plastic and the metal frame is further increased, the connection stability and the bonding strength between the insulating plastic and the metal frame are improved, so that when the antenna slot structure is bent, squeezed, or dropped, or encounters another case, the insulating plastic at the concave surface of the first groove and a contact area of the metal frame do not tend to relatively move. Therefore, possibility of cracking of the insulating plastic at the concave surface of the first groove is reduced, the airtightness of the electronic device is enhanced, and the dustproof and waterproof capabilities of the electronic device are further ensured.

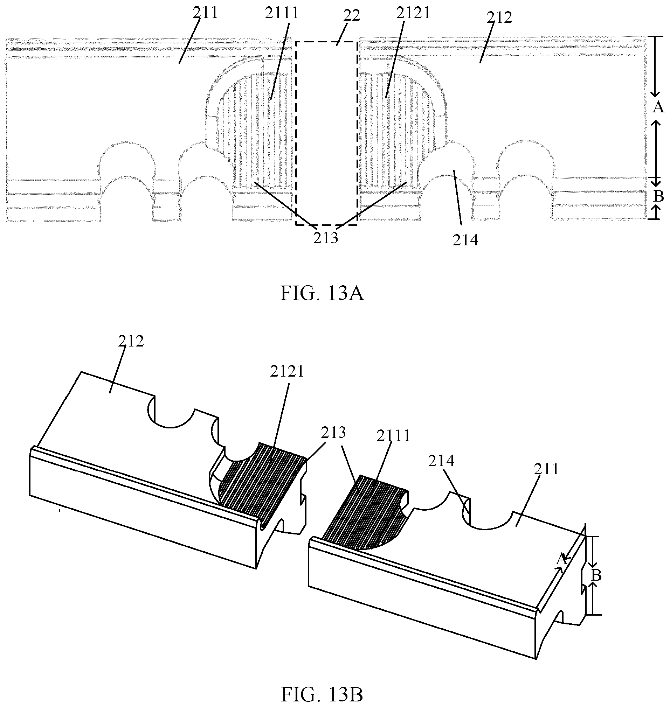

Refer to FIG. 13A and FIG. 13B together. FIG. 13A is a schematic diagram of a metal frame of still another antenna slot structure according to an embodiment of this application. FIG. 13B is a schematic diagram of a metal frame corresponding to FIG. 13A from a different perspective according to an embodiment of this application.

For a first groove on the first part 211 and the second part 212, a milled trench or a laser carving provided on a concave surface of the first groove is marked with 213.

With the milled trench or the laser carving on the concave surface of the first groove, a contact area between the insulating plastic and the metal frame is further increased, the connection stability and the bonding strength between the insulating plastic at the concave surface of the first groove and the metal frame are improved, so that when the antenna slot structure is bent, squeezed, or dropped, or encounters another case, the insulating plastic at the concave surface of the first groove and the metal frame do not tend to relatively move. Therefore, a possibility of cracking of the insulating plastic at the concave surface of the first groove is reduced, the airtightness of the electronic device is enhanced, and the dustproof and waterproof capabilities of the electronic device are further ensured.

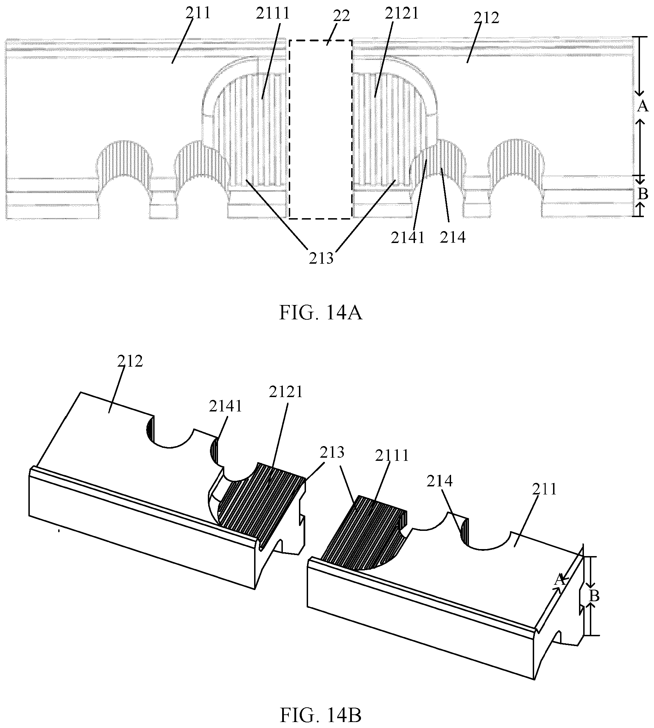

Refer to FIG. 14A and FIG. 14B together. FIG. 14A is a schematic diagram of a metal frame of another antenna slot structure according to an embodiment of this application. FIG. 14B is a schematic diagram of a metal frame corresponding to FIG. 14A from a different perspective according to an embodiment of this application.

For a first groove on the first part 211 and the second part 212, a milled trench or a laser carving provided on a concave surface of the first groove is marked with 213. For a second groove 214 on the first part 211 and the second part 212, a milled trench or a laser carving on a concave surface of the second groove is marked with 2141.

In this solution, the first groove and the second groove are both provided with a milled trench or both provided with a laser carving, increasing the connection stability and bonding strength between insulating plastic at the concave surfaces of the first groove and the second groove and the metal frame, so that when the antenna slot structure is bent, squeezed, or dropped, or encounters another case, the insulating plastic at the concave surfaces of the first groove and the second groove and the metal frame do not tend to relatively move. Therefore, possibility of cracking of the insulating plastic at the concave surfaces of the first groove and the second groove is reduced, the airtightness of the electronic device is enhanced, and the dustproof and waterproof capabilities of the electronic device are further ensured.

In the foregoing embodiment, for the two second grooves included in the first part or the second part of the antenna slot structure, a notch of one of the second grooves on the first side is located outside the first groove, and a notch of the other of the second grooves on the first side is located on the concave surface of the first groove.

Another implementation of a relative position relationship between the first groove and the second groove when the antenna slot structure includes both the first groove and the second groove is described below.

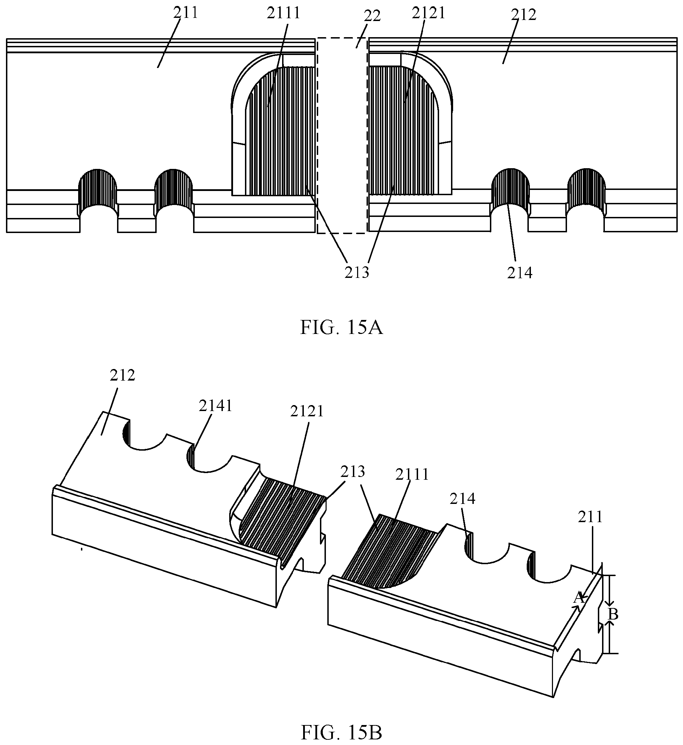

Refer to FIG. 15A and FIG. 15B together. FIG. 15A is a schematic diagram of a metal frame of still another antenna slot structure according to an embodiment of this application, and FIG. 15B is a schematic diagram of a metal frame corresponding to FIG. 15A from a different perspective according to an embodiment of this application.

In this implementation, each of the first part 211 and the second part 212 includes two second grooves.

An end of each second groove extends to the first side, a notch of each second groove on the first side is entirely located outside a groove surface of the first groove. The first groove and the second groove are separated from each other in physical position, thereby facilitating processing.

For a second groove 214 on the first part 211 and the second part 212, a milled trench or a laser carving on a concave surface of the second groove is marked with 2141.

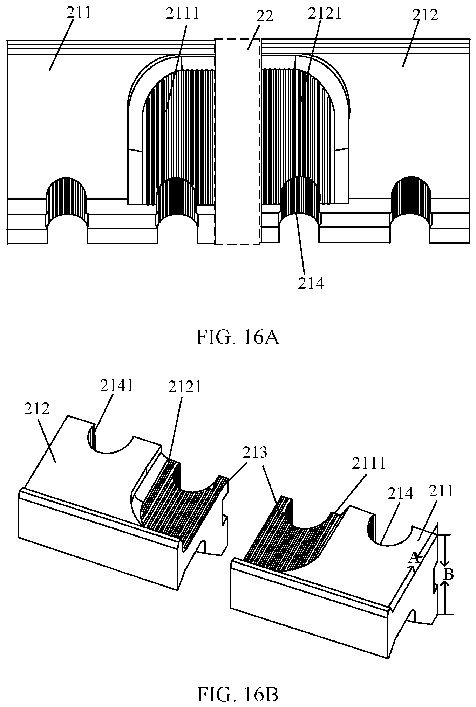

Refer to FIG. 16A and FIG. 16B together. FIG. 16A is a schematic diagram of a metal frame of still another antenna slot structure according to an embodiment of this application. FIG. 16B is a schematic diagram of a metal frame corresponding to FIG. 16A from a different perspective according to an embodiment of this application.

In this implementation, each of the first part 211 and the second part 212 includes two second grooves. The first part 211 and the second part 212 are symmetrical relative to the antenna slot 22. The second groove included in the first part 211 is used as an example for descriptions below.

A notch of one second groove included in the first part 211 on the first side is entirely located in a groove surface of the first groove, and a notch of the other second groove included in the first part 211 on the first side is entirely located outside the groove surface of the first groove.

In this implementation, since a notch of a second groove on the first side is entirely located on the groove surface of the first groove, an occupied size of the second groove during arrangement can be reduced, that is, comparing the manners shown in FIG. 16 and FIG. 15, it can be found that when a same quantity of second grooves are arranged, a size of the antenna slot structure shown in FIG. 16 is less.

For a second groove 214 on the first part 211 and the second part 212, a milled trench or a laser carving on a concave surface of the second groove is marked with 2141.

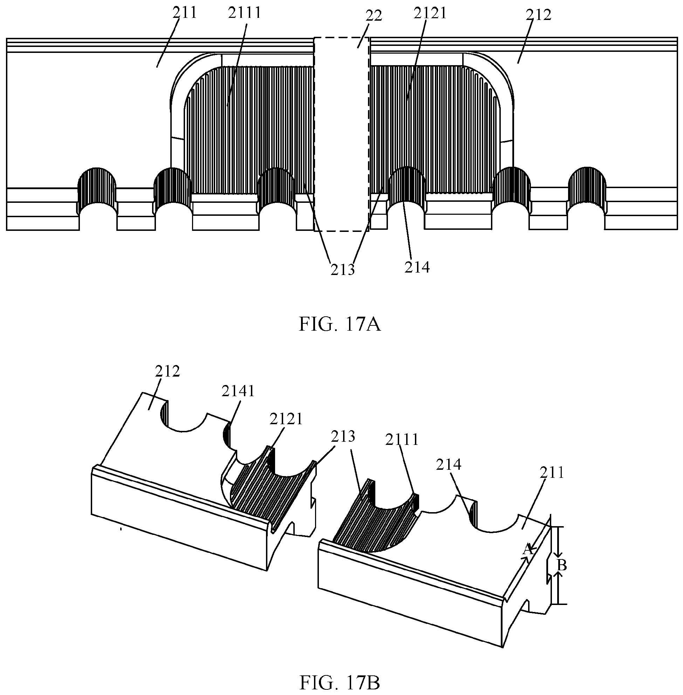

Refer to FIG. 17A and FIG. 17B together. FIG. 17A is a schematic diagram of a metal frame of another antenna slot structure according to an embodiment of this application. FIG. 17B is a schematic diagram of a metal frame corresponding to FIG. 17A from a different perspective according to an embodiment of this application.

In this implementation, each of the first part 211 and the second part 212 includes three second grooves. The first part 211 and the second part 212 are symmetrical relative to the antenna slot 22. The second groove included in the first part 211 is used as an example for descriptions below.

A notch of one second groove included in the first part 211 on the first side is entirely located in a groove surface of the first groove, the first part 211 further includes one second groove whose notch on the first side is entirely located outside the groove surface of the first groove, and the first part 211 further includes a second groove whose notch on the first side is partially located outside the groove surface of the first groove and partially located in the groove surface of the first groove.

In this implementation, since a notch of a second groove on the first side is entirely located in the groove surface of the first groove, and a notch of a second groove on the first side is partially located on the groove surface of the first groove, an occupied size of the second groove during arrangement can be reduced, that is, comparing the manners shown in FIG. 17 and FIG. 15, it can be found that although a larger quantity of second grooves are provided in FIG. 17, a size of the antenna slot structure shown in FIG. 17 is not clearly increased.

For a second groove 214 on the first part 211 and the second part 212, a milled trench or a laser carving on a concave surface of the second groove is marked with 2141.

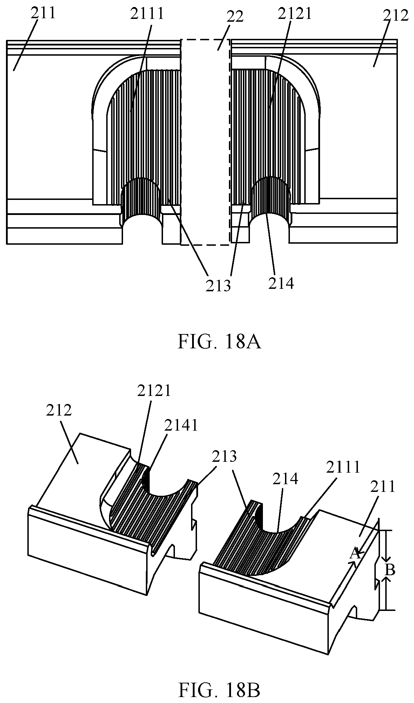

Refer to FIG. 18A and FIG. 18B together. FIG. 18A is a schematic diagram of a metal frame of yet another antenna slot structure according to an embodiment of this application, and FIG. 18B is a schematic diagram of a metal frame corresponding to FIG. 18A from a different perspective according to an embodiment of this application.

In this implementation, each of the first part 211 and the second part 212 includes a second groove. A notch of the second groove shown in the figures on the first side is entirely located on a concave surface of the first groove.

In this implementation, a size of the antenna slot structure can be fully reduced.

In addition, in some other possible implementations, when each of the first part 211 and the second part 212 includes a second groove, a notch of the second groove on the first side may be entirely located on the concave surface of the first groove, or a notch of the second groove on the first side may be partially located on the concave surface of the first groove.

For a second groove 214 on the first part 211 and the second part 212, a milled trench or a laser carving on a concave surface of the second groove is marked with 2141.

Based on the antenna slot structure provided in the foregoing embodiments, the embodiments of this application further provide an electronic device. An antenna and an antenna slot structure provided in the foregoing embodiments are arranged in the electronic device. An example in which an electronic device is a mobile phone is used for descriptions below in detail with accompanying drawings.

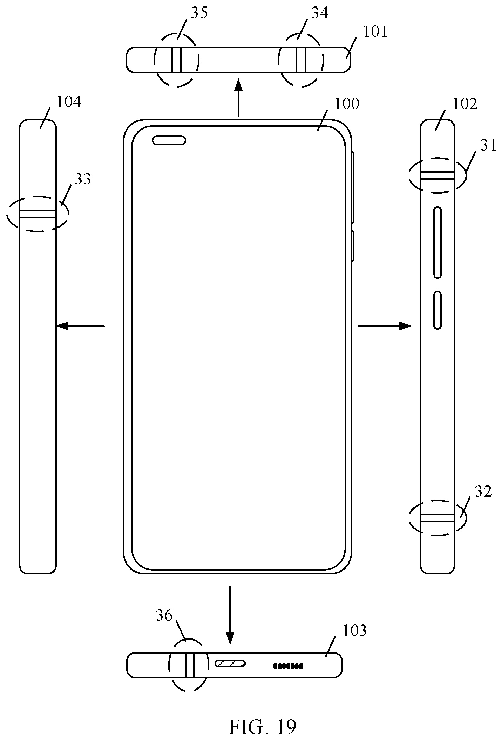

FIG. 19 is a schematic diagram of an electronic device according to an embodiment of this application.

The electronic device 100 includes one or more antenna slot structures provided in the foregoing embodiments, and an example in which a plurality of antenna slot structures provided in the foregoing embodiments are included is used for descriptions below in detail.

The electronic device 100 includes a first short edge 101, a first long edge 102, a second short edge 103, and a second long edge 104.

As shown in FIG. 19, when the electronic device 100 is in a portrait state, the first short edge 101 is an upper edge of the electronic device 100, the first long edge 102 is a right edge of the electronic device 100, the second short edge 103 is a lower edge of the electronic device 100, and the second long edge 103 is a left edge of the electronic device 100.

The plurality of antenna slot structures include a first group of antenna slot structures and a second group of antenna slot structures. The first group of antenna slot structures is located on the first long edge 102, and the second group of antenna slot structures is located on the second long edge 104.

That is, the first group of antenna slot structures in FIG. 19 includes antenna slot structures 31 and 32. The second group of antenna slot structures includes antenna slot structure 33.

In this case, the antenna slot structure shown in FIG. 3 may be arranged on the first short edge 101 and the second short edge 103 of the electronic device may, or the antenna slot structure may not be arranged, which is not specifically limited in this embodiment of this application.

An antenna structure provided in this embodiment of this application is preferentially arranged on a long edge of the electronic device, because compared with a short edge, the long edge of the electronic device is more likely to be bent, squeezed, or dropped, or encounter another case during assembly or use, and the metal frame and the insulating plastic in the antenna slot structure are disconnected, or the insulating plastic is cracked. Therefore, the antenna slot structure provided in this embodiment of this application is arranged on the long edge of the electronic device.

In some other embodiments, to further ensure reliability of the antenna slot structure, the plurality of antenna slot structures include a third group of antenna slot structures and a fourth group of antenna slot structures. The third group of antenna slot structures is located on the first short edge 101, and the fourth group of antenna slot structures is located on the second short edge 103.

That is, the third antenna slot structure in FIG. 19 includes antenna slot structures 34 and 35. The second group of antenna slot structures includes antenna slot structure 36.

In this case, all the antenna slot structures adopt the implementations provided in this embodiment of this application, enhance the airtightness of the electronic device, and further ensure the dustproof and waterproof capabilities of the electronic device.

A specific quantity of the antenna slots included in the first group of antenna slots, the second group of antenna slots, the third group of antenna slots, and the fourth group of antenna slots are not limited in this embodiment of this application, and the foregoing description is only a possible implementation.

For a specific implementation and principle of the antenna slot structure, reference may be made to related description in the foregoing embodiment. Details are not described again in this embodiment of this application.

A shape of the electronic device listed in this embodiment of this application is only a possible implementation, and does not constitute a limitation to the technical solutions of this application.

The electronic device provided in this application may be a mobile phone, a notebook computer, a wearable electronic device (such as a smart watch), a tablet computer, an AR device, a VR device, an in-vehicle device, and the like, and is not specifically limited in this embodiment of this application.

In summary, the first groove and/or the second groove is arranged in the antenna slot structure of the electronic device, after the groove and the antenna slot are both filled with the insulating plastic, a contact area between the insulating plastic and the metal frame is increased, and the connection stability and the bonding strength between the insulating plastic and the metal frame are further improved. Specifically, after the first groove is filled with the insulating plastic, a thickness of insulating plastic near the antenna slot is improved, and possibility of cracking of the insulating plastic near the antenna slot is reduced. The second groove can limit and clamp the insulating plastic, so that when the antenna slot structure is bent, squeezed, or dropped, or encounters another case, possibility of cracking is reduced. Therefore, the airtightness of the electronic device is enhanced, and the dustproof and waterproof capabilities of the electronic device are further ensured.

It should be understood that in this application, "at least one" refers to one or more, and "a plurality of" refers to two or more. The term "and/or" is used for describing an association between associated objects and representing that three associations may exist. For example, "A and/or B" may indicate that only A exists, only B exists, and both A and B exist, where A and B may be singular or plural. The character "/" generally indicates an "or" relationship between associated objects before and after the character. "At least one of the following" or a similar expression thereof refers to any combination of these items, including one item or any combination of a plurality of items. For example, at least one of a, b, or c may indicate that a, b, c, "a and b", "a and c", "b and c", or "a, b, and c", where a, b, and c may be singular or plural.

Based on the above, the foregoing embodiments are merely for describing the technical solutions of this application, but not for limiting. Although this application has been described in detail with reference to the foregoing embodiments, a person skilled in the art should understand that, the technical solutions described in the foregoing embodiments can still be modified, or equivalent replacement may be performed on some technical features without departing from the scope of this application as defined by the appended claims.

## Claims

1. An antenna slot structure (20, 31-36), wherein the antenna slot structure (20, 31-36) comprises: insulating plastic (23) and a metal frame (21), wherein
the metal frame (21) comprises a first part (211) and a second part (202, 211, 212), and the first part (211) and the second part (202, 211, 212) are separated to form an antenna slot (20, 22);
at least one of the first part (211) and the second part (202, 211, 212) is provided with a first groove (2111, 2121) at the antenna slot (20, 22);
the first groove (2111, 2121) starts from the antenna slot (20, 22) and extends toward a direction away from the antenna slot (20, 22); and
the insulating plastic (23) fills the first groove (2111, 2121) and the antenna slot (20, 22);
wherein the metal frame (21) comprises a first side (A) and a second side (B) connected in sequence, and the first groove (2111, 2121) is located on the first side;
at least one of the first part (211) and the second part (202, 211, 212) is further provided with a plurality of second grooves (214) on the second side (B); and
the insulating plastic (23) covers the first side and the second side (214) and fills the plurality of second grooves (214); and
the plurality of second grooves (214) extend to the first side;
a notch of one of the plurality of second grooves (214) on the first side is partially located on the concave surface of the first groove (2111, 2121); and
the plurality of second grooves (214) comprise at least one second groove (214) whose notch on the first side is located outside the first groove (2111, 2121).

2. The antenna slot structure (20, 31-36) according to claim 1, wherein a concave surface of the first groove (2111, 2121) comprises at least one of the following:
a milled trench or a laser carving.

3. The antenna slot structure (20, 31-36) according to claim 1, wherein the plurality of second grooves (214) further comprise at least one second groove (214) whose notch on the first side is entirely located on the concave surface of the first groove (2111, 2121).

4. The antenna slot structure (20, 31-36) according to any one of claims 1 to 3, wherein a concave surface of the plurality of second grooves (214) comprises at least one of the following:
a milled trench or a laser carving.

5. The antenna slot structure (20, 31-36) according to any one of claims 1 to 4, wherein the plurality of second grooves (214) comprise at least one of the following:
a through groove or a blind groove.

6. The antenna slot structure (20, 31-36) according to any one of claims 1 to 5, wherein the first part (211) and the second part (202, 211, 212) both comprise at least one second groove (214) of the plurality of second grooves (214), and a quantity of second grooves (214) comprised in the first part (211) is equal to a quantity of second grooves (214) comprised in the second part (202, 211, 212).

7. The antenna slot structure (20, 31-36) according to any one of claims 1 to 6, wherein the first part (211) and the second part (202, 211, 212) both comprise the first groove (2111, 2121), and a quantity of first grooves (2111, 2121) comprised in the first part (211) is equal to a quantity of first grooves (2111, 2121) comprised in the second part (202, 211, 212).

8. An electronic device (100), wherein the electronic device (100) comprises one or more antenna slot structures (20, 31, 32, 34, 35) according to any one of claims 1 to 7.

9. The electronic device (100) according to claim 8, wherein the electronic device (100) comprises a plurality of antenna slot structures (20, 31, 32, 34, 35), and further comprises a first short edge (101), a first long edge (102), a second short edge (103), and a second long edge (103, 104) connected in sequence;
the plurality of antenna slot structures (20, 31, 32, 34, 35) comprise a first group of antenna slot structures (20, 31, 32, 34, 35) and a second group of antenna slot structures (20, 31, 32, 34, 35);
the first group of antenna slot structures (20, 31, 32, 34, 35) is located on the first long edge (102); and
the second group of antenna slot structures (20, 31, 32, 34, 35) is located on the second long edge (103, 104).

10. The electronic device (100) according to claim 9, wherein the plurality of antenna slot structures (20, 31, 32, 34, 35) further comprises a third group of antenna slot structures (20, 31, 32, 34, 35) and a fourth group of antenna slot structures (20, 31, 32, 34, 35);
the third group of antenna slot structures (20, 31, 32, 34, 35) is located on the first short edge (101); and
the fourth group of antenna slot structures (20, 31, 32, 34, 35) is located on the second short edge (103).

## Patentansprüche

1. Eine Antennenschlitzstruktur (20, 31-36), wobei die Antennenschlitzstruktur (20, 31-36) folgendes umfasst: Isolierkunststoff (23) und einen Metallrahmen (21), wobei
der Metallrahmen (21) einen ersten Teil (211) und einen zweiten Teil (202, 211, 212) umfasst und der erste Teil (211) und der zweite Teil (202, 211, 212) voneinander getrennt sind, so dass ein Antennenschlitz (20, 22) gebildet wird;
mindestens einer der erste Teil (211) und der zweite Teil (202, 211, 212) ist am Antennenschlitz (20, 22) mit einer ersten Nut (2111, 2121) versehen;
die erste Nut (2111, 2121) beginnt am Antennenschlitz (20, 22) und erstreckt sich in eine vom Antennenschlitz (20, 22) wegführende Richtung; und
der Isolierkunststoff (23) füllt die erste Nut (2111, 2121) und den Antennenschlitz (20, 22); wobei der Metallrahmen (21) eine erste Seite (A) und eine zweite Seite (B) umfasst, die der Reihe nach verbunden sind, und die erste Nut (2111, 2121) sich auf der ersten Seite befindet;
mindestens einer der erste Teil (211) und der zweite Teil (202, 211, 212) ist ferner mit einer Vielzahl von zweiten Nuten (214) auf der zweiten Seite (B) versehen; und
der Isolierkunststoff (23) bedeckt die erste und die zweite Seite (214) und füllt die Vielzahl von zweiten Nuten (214); und
die Vielzahl der zweiten Nuten (214) erstreckt sich bis zur ersten Seite;
eine Einkerbung einer der Vielzahl von zweiten Nuten (214) auf der ersten Seite befindet sich teilweise auf der konkaven Fläche der ersten Nut (2111, 2121); und
die Vielzahl von zweiten Nuten (214) umfasst mindestens eine zweite Nut (214), deren Einkerbung auf der ersten Seite außerhalb der ersten Nut (2111, 2121) liegt.

2. Die Antennenschlitzstruktur (20, 31-36) gemäß Anspruch 1, wobei eine konkave Fläche der ersten Nut (2111, 2121) mindestens eines der folgenden umfasst:
eine gefräste Rinne oder eine Lasergravur.

3. Die Antennenschlitzstruktur (20, 31-36) gemäß Anspruch 1, wobei die Vielzahl der zweiten Nuten (214) mindestens eine zweite Nut (214) umfasst, deren Einkerbung auf der ersten Seite vollständig auf der konkaven Fläche der ersten Nut (2111, 2121) liegt.

4. Die Antennenschlitzstruktur (20, 31-36) gemäß einem der Ansprüche 1 bis 3, wobei eine konkave Fläche der Vielzahl der zweiten Nuten (214) mindestens eines der folgenden umfasst:
eine gefräste Rinne oder eine Lasergravur.

5. Die Antennenschlitzstruktur (20, 31-36) gemäß einem der Ansprüche 1 bis 4, wobei die Vielzahl der zweiten Nuten (214) mindestens eines der folgenden umfasst:
eine Durchgangsnut oder eine Sacknut.

6. Die Antennenschlitzstruktur (20, 31-36) nach einem der Ansprüche 1 bis 5, wobei der erste Teil (211) und der zweite Teil (202, 211, 212) jeweils mindestens eine zweite Nut (214) der Mehrzahl von zweiten Nuten (214) umfassen und die Anzahl der im ersten Teil (211) enthaltenen zweiten Nuten (214) gleich der Anzahl der im zweiten Teil (202, 211, 212) enthaltenen zweiten Nuten (214) ist.

7. Die Antennenschlitzstruktur (20, 31-36) nach einem der Ansprüche 1 bis 6, wobei der erste Teil (211) und der zweite Teil (202, 211, 212) jeweils die erste Nut (2111, 2121) umfassen und die Anzahl der im ersten Teil (211) enthaltenen ersten Nuten (2111, 2121) gleich der Anzahl der im zweiten Teil (202, 211, 212) enthaltenen ersten Nuten (2111, 2121) ist.

8. Ein elektronisches Gerät (100), wobei das elektronische Gerät (100) eine oder mehrere Antennenschlitzstrukturen (20, 31, 32, 34, 35) gemäß einem der Ansprüche 1 bis 7 umfasst.

9. Das elektronische Gerät (100) nach Anspruch 8, wobei das elektronische Gerät (100) mehrere Antennenschlitzstrukturen (20, 31, 32, 34, 35) sowie eine erste kurze Kante (101), eine erste lange Kante (102), eine zweite kurze Kante (103) und eine zweite lange Kante (103, 104), die nacheinander verbunden sind, umfasst;
die Mehrzahl der Antennenschlitzstrukturen (20, 31, 32, 34, 35) umfasst eine erste Gruppe von Antennenschlitzstrukturen (20, 31, 32, 34, 35) und eine zweite Gruppe von Antennenschlitzstrukturen (20, 31, 32, 34, 35);
die erste Gruppe von Antennenschlitzstrukturen (20, 31, 32, 34, 35) befindet sich an der ersten langen Kante (102); und
die zweite Gruppe von Antennenschlitzstrukturen (20, 31, 32, 34, 35) befindet sich an der zweiten langen Kante (103, 104).

10. Das elektronische Gerät (100) nach Anspruch 9, wobei die Mehrzahl der Antennenschlitzstrukturen (20, 31, 32, 34, 35) weiterhin eine dritte Gruppe von Antennenschlitzstrukturen (20, 31, 32, 34, 35) und eine vierte Gruppe von Antennenschlitzstrukturen (20, 31, 32, 34, 35) umfasst;
die dritte Gruppe von Antennenschlitzstrukturen (20, 31, 32, 34, 35) befindet sich an der ersten kurzen Kante (101); und
die vierte Gruppe von Antennenschlitzstrukturen (20, 31, 32, 34, 35) befindet sich an der zweiten kurzen Kante (103).

## Revendications

1. Une structure de fente d'antenne (20, 31-36), dans laquelle la structure de fente d'antenne (20, 31-36) comprend : une matière plastique isolante (23) et un cadre métallique (21), dans laquelle
le cadre métallique (21) comprend une première partie (211) et une seconde partie (202, 211, 212), et la première partie (211) et la seconde partie (202, 211, 212) sont séparées pour former une fente d'antenne (20, 22) ;
au moins l'une de la première partie (211) et de la seconde partie (202, 211, 212) est pourvue d'une première rainure (2111, 2121) au niveau de la fente d'antenne (20, 22) ;
la première rainure (2111, 2121) débute à partir de la fente d'antenne (20, 22) et s'étend dans une direction s'éloignant de la fente d'antenne (20, 22) ; et
la matière plastique isolante (23) remplit la première rainure (2111, 2121) et la fente d'antenne (20, 22) ;
le cadre métallique (21) comprend un premier côté (A) et un second côté (B) connectés en séquence, et la première rainure (2111, 2121) est située sur le premier côté ;
au moins l'une de la première partie (211) et de la seconde partie (202, 211, 212) est également pourvue d'une pluralité de secondes rainures (214) sur le second côté (B) ; et
la matière plastique isolante (23) recouvre le premier côté et le second côté (214) et remplit la pluralité de secondes rainures (214) ; et
la pluralité de secondes rainures (214) s'étendent jusqu'au premier côté ;
une encoche d'une des nombreuses secondes rainures (214) sur le premier côté est partiellement située sur la surface concave de la première rainure (2111, 2121) ; et
la pluralité de secondes rainures (214) comprend au moins une seconde rainure (214) dont l'encoche sur le premier côté est située à l'extérieur de la première rainure (2111, 2121).

2. La structure de fente d'antenne (20, 31-36) selon la revendication 1, dans laquelle une surface concave de la première rainure (2111, 2121) comprend au moins l'un des éléments suivants :
une tranchée fraisée ou une gravure au laser.

3. La structure de fente d'antenne (20, 31-36) selon la revendication 1, dans laquelle la pluralité de secondes rainures (214) comprend en outre au moins une seconde rainure (214) dont l'encoche sur le premier côté est entièrement située sur la surface concave de la première rainure (2111, 2121).

4. La structure de fente d'antenne (20, 31-36) selon l'une quelconque des revendications 1 à 3, dans laquelle une surface concave de la pluralité de secondes rainures (214) comprend au moins l'un des éléments suivants :
une tranchée fraisée ou une gravure au laser.

5. La structure de fente d'antenne (20, 31-36) selon l'une quelconque des revendications 1 à 4, dans laquelle la pluralité de secondes rainures (214) comprend au moins l'un des éléments suivants :
une rainure traversante ou une rainure borgne.

6. La structure de fente d'antenne (20, 31-36) selon l'une quelconque des revendications 1 à 5, dans laquelle la première partie (211) et la deuxième partie (202, 211, 212) comprennent toutes deux au moins une seconde rainure (214) parmi la pluralité de secondes rainures (214), et une quantité de secondes rainures (214) contenue dans la première partie (211) est égale à une quantité de secondes rainures (214) contenue dans la deuxième partie (202, 211, 212).

7. La structure de fente d'antenne (20, 31-36) selon l'une quelconque des revendications 1 à 6, dans laquelle la première partie (211) et la deuxième partie (202, 211, 212) comprennent toutes deux la première rainure (2111, 2121), et une quantité de premières rainures (2111, 2121) contenue dans la première partie (211) est égale à une quantité de premières rainures (2111, 2121) contenue dans la deuxième partie (202, 211, 212).

8. Un dispositif électronique (100), dans lequel le dispositif électronique (100) comprend une ou plusieurs structures de fente d'antenne (20, 31, 32, 34, 35) selon l'une quelconque des revendications 1 à 7.

9. Le dispositif électronique (100) selon la revendication 8, dans lequel le dispositif électronique (100) comprend une pluralité de structures de fente d'antenne (20, 31, 32, 34, 35), et comprend en outre un premier bord court (101), un premier bord long (102), un deuxième bord court (103) et un deuxième bord long (103, 104) connectés en séquence ;
la pluralité de structures de fente d'antenne (20, 31, 32, 34, 35) comprend un premier groupe de structures de fente d'antenne (20, 31, 32, 34, 35) et un deuxième groupe de structures de fente d'antenne (20, 31, 32, 34, 35) ;
le premier groupe de structures de fente d'antenne (20, 31, 32, 34, 35) est situé sur le premier bord long (102) ; et
le deuxième groupe de structures de fente d'antenne (20, 31, 32, 34, 35) est situé sur le deuxième bord long (103, 104).

10. Le dispositif électronique (100) selon la revendication 9, dans lequel la pluralité de structures de fente d'antenne (20, 31, 32, 34, 35) comprend en outre un troisième groupe de structures de fente d'antenne (20, 31, 32, 34, 35) et un quatrième groupe de structures de fente d'antenne (20, 31, 32, 34, 35) ;
le troisième groupe de structures de fente d'antenne (20, 31, 32, 34, 35) est situé sur le premier bord court (101) ; et
le quatrième groupe de structures de fente d'antenne (20, 31, 32, 34, 35) est situé sur le deuxième bord court (103).
